# FASCICULE DE BREVET EUROPEEN

(11) **EP 2 988 378 B1**
(45) Date de publication et mention de la délivrance du brevet: **26.04.2017**
(21) Numéro de dépôt: 15181819.2
(22) Date de dépôt: 20.08.2015
(51) Int. Cl.: H01S 5/026, H01S 5/10, H01S 5/12, H01S 5/02, H01S 5/022, H01S 5/042, H01S 5/187, H01S 5/323, G02B 6/12, G02B 6/30, G02B 6/34

(54) **DISPOSITIF LASER ET PROCÉDÉ DE FABRICATION D'UN TEL DISPOSITIF LASER**
LASERVORRICHTUNG UND HERSTELLUNGSVERFAHREN EINER SOLCHEN LASERVORRICHTUNG
LASER DEVICE AND METHOD FOR MANUFACTURING SUCH A LASER DEVICE

(30) Priorité: 22.08.2014 FR 1457937
(43) Date de publication de la demande: 24.02.2016
(73) Titulaire: Commissariat à l'Énergie Atomique et aux Énergies Alternatives, 75015 Paris (FR); STmicroelectronics SA, 92120 Montrouge (FR); STMicroelectronics (Crolles 2) SAS, 38920 Crolles (FR)
(72) Inventeur: FERROTTI, Thomas, 38000 GRENOBLE (FR); BEN BAKIR, Badhise, 38590 BREZINS (FR); CHANTRE, Alain, 38180 SEYSSINS (FR); CREMER, Sébastien, 38360 SASSENAGE (FR); DUPREZ, Hélène, 38170 SEYSSINET-PARISET (FR)
(74) Mandataire: GIE Innovation Competence Group

(56) Documents cités:
- US-A1- 2013 259 077
- STANKOVIC S ET AL: "Hybrid III V/Si Distributed-Feedback Laser Based on Adhesive Bonding", IEEE PHOTONICS TECHNOLOGY LETTERS, IEEE SERVICE CENTER, PISCATAWAY, NJ, US, vol. 24, no. 23, 1 décembre 2012 (2012-12-01), pages 2155-2158, XP011488545, ISSN: 1041-1135, DOI: 10.1109/LPT.2012.2223666
- B. BEN BAKIR ET AL: "Electrically driven hybrid Si/III-V lasers based on adiabatic mode transformers", PROCEEDINGS OF SPIE, vol. 7719, 17 mai 2010 (2010-05-17), pages 77191F-77191F-9, XP055000619, ISSN: 0277-786X, DOI: 10.1117/12.858889

## Description

### DOMAINE TECHNIQUE

La présente invention se rapporte au domaine des composants photoniques intégrés qui utilisent à la fois les propriétés des matériaux semi-conducteurs aptes à émettre de la lumière et celles des matériaux semi-conducteurs utilisés classiquement dans les circuits intégrés.

Plus particulièrement, la présente invention concerne un dispositif laser et un procédé de fabrication d'un tel dispositif laser.

Un tel dispositif laser peut être employé pour réaliser des liaisons optiques à grandes vitesses, des liaisons intrapuces, intracartes, en espace libre.

### ÉTAT DE LA TECHNIQUE ANTÉRIEURE

Dans le document « Hybrid silicon evanescent laser fabricated with a silicon waveguide and III-V offset quantum wells » Hyundai Park et al. 2909491 4 Optics Express, vol. 13, N 23, 14 November 2005, pages 9460-9464, il est décrit une source laser en matériau III-V reportée sur un substrat SOI dans lequel est façonné un guide d'onde en arête (« RIB waveguide » en anglais) formé d'un guide d'onde en ruban (« slab waveguide » en anglais) surmonté d'une arête ou nervure (« rib » en anglais »).

Le couplage entre la source laser et le guide d'onde se fait par onde évanescente. Des miroirs bornant la cavité sont réalisés par sciage et polissage. La source laser et le guide d'onde sont autonomes. Le pompage de la cavité amplificatrice est optique. L'inconvénient de cette structure réside dans la réalisation des miroirs, il faut faire une étape dite de polisciage, le polissage et le sciage sont simultanés. Le polisciage est très délicat à réaliser, il s'agit d'un procédé non collectif et difficilement industrialisable.

On connaît aussi par la demande de brevet français FR-A-2 826 789 un laser intégré sur un même substrat avec un modulateur, un amplificateur ou un filtre dans lequel à la fois une structure émettrice de lumière et un réseau de diffraction sont réalisés en technologie III-V et sont mis bout à bout. Il n'y a rien en technologie silicium et ce composant optique serait à associer à un composant technologie silicium avec les inconvénients évoqués plus haut.

On connaît aussi du document WO2012066200 un laser comportant un amplificateur à hétérostructure de type III-V, agencée pour générer des photons, un guide d'onde en arête, couplé optiquement à l'amplificateur, et comportant une section en forme de créneau ou arête dont le sommet est proximal de l'amplificateur.

La partie centrale du laser peut être vue comme deux guides couplés verticalement, et séparés par une couche d'oxyde d'une centaine de nanomètres : un guide d'onde supérieur « actif » qui constitue le milieu amplificateur (ou milieu à gain), et un guide d'onde inférieur transparent ou circuit photonique passif qui sert à véhiculer la lumière et dans lequel toutes les fonctions optiques sont assurées. Le guide actif est défini dans une hétérostructure III-V dopée dans laquelle sont disposés des puits (ou boîtes) quantiques.

La cavité laser est donc définie par un miroir de Bragg située sous le laser, et gravée dans l'arête du guide de silicium.

L'arête a aussi pour fonction d'être un transformateur adiabatique de mode. A cet effet, depuis sa section la plus faible située sous le milieu amplificateur, elle s'élargit progressivement jusqu'au guide d'onde de sortie.

Pour les lasers à rétroaction distribuée (« DFB » en anglais pour « Distributed FeedBack ») du document précité, la réflectivité recherchée est située entre 65 et 80%.

Or dans le présent cas pour un couplage contre-directionnel, la réflectivité par unité de longueur dépend de la différence d'indices effectifs entre les zones gravées et non gravées du réseau (un réseau gravé plus profondément aura une réflectivité par unité de longueur plus élevée), mais aussi de la largeur de celui-ci.

Cependant, dans le cadre d'un laser DFB, la largeur du réseau est fixée par la largeur d'entrée du transformateur de modes, c'est-à-dire le guide en arête.

Il s'est avéré qu'une largeur minimale de 0.7µm est nécessaire pour obtenir la réflectivité désirée, alors que la largeur de départ d'un transformateur de modes peut être bien inférieure à cette valeur (jusqu'à 0.4µm). Dans ce cas, il est nécessaire d'effectuer la transformation du mode pour une largeur de départ plus élevée, afin d'obtenir la réflectivité requise (troncature du transformateur de modes). Cette opération va cependant réduire le confinement du mode dans le guide actif, et diminuer l'efficacité du laser. La largeur d'arête limite pour commencer la transformation du mode se situe aux environs de 0.8 µm.

On comprend donc que pour ces lasers de type DFB, il est difficile d'obtenir à la fois une réflectivité élevée et un couplage efficace entre les guides actifs et passifs.

La présente invention vise à pallier, au moins partiellement, les inconvénients précités en proposant un dispositif laser où la réflectivité du réseau de Bragg peut être découplée de la largeur de l'arête du guide d'onde en arête.

A cet effet, la présente invention propose un dispositif laser disposé dans et/ou sur silicium et à hétéro structure III-V comprenant
- un milieu amplificateur à hétérostructure III-V, et
- un guide d'onde optique en arête, disposé en regard du milieu amplificateur et comprenant un guide d'onde en ruban doté d'une arête longitudinale, le guide d'onde optique en arête étant disposé dans du silicium,
caractérisé en ce que le guide d'onde optique en arête est orienté de manière à ce qu'au moins un réseau de Bragg est disposée sur la face du guide d'onde en ruban qui est proximale par rapport au milieu amplificateur et en ce que l'arête est disposée sur la face du guide d'onde en ruban qui est distale par rapport au milieu amplificateur.

En particulier en dé-corrélant la largeur du réseau et la largeur de l'arête, on gagne un degré de liberté supplémentaire : on peut réaliser un réseau plus large que l'arête pour améliorer la réflectivité, et garder une arête fine pour optimiser le couplage.
Le dispositif laser peut comporter un ou plusieurs des aspects suivants pris seuls ou en combinaison :
Selon un mode de réalisation, le dispositif laser comprend deux réseaux de Bragg disposés de part et d'autre par rapport au milieu amplificateur à hétérostructure III-V.

Dans ce cas, le réseau de Bragg qui se trouve du côté d'un réseau de sortie possède par exemple une réflectivité de l'ordre de 50% et le réseau de Bragg sur le côté opposé du milieu amplificateur possède par exemple une réflectivité supérieure à 90%.

Selon un autre mode de réalisation, le dispositif laser comprend un réseau de Bragg en regard du milieu amplificateur à hétérostructure III-V. Il s'agit dans ce cas notamment d'un unique réseau de Bragg.

Dans ce cas, le réseau de Bragg comprend une lame quart d'onde pour assurer un fonctionnement monomode.

Pour ce mode de réalisation, la réflectivité du réseau de Bragg est comprise entre 65% et 80%.

Selon les aspects suivants, valables pour l'un ou l'autre des modes de réalisation :
- la largeur du réseau de Bragg est supérieure à celle de l'arête,
- la largeur du réseau de Bragg est sensiblement égale à la largeur du guide d'onde en ruban,
- la largeur de l'arête du guide d'onde en arête augmente en direction d'un guide d'onde de sortie pour former un transformateur de mode,
- la largeur minimale de l'arête est comprise entre 0.4µm et 0.7µm,
- la largeur maximale de l'arête est supérieure à 1µm, notamment 1.1µm,
- la hauteur de l'arête est comprise entre 100nm et 250nm, en particulier 200nm,
- la hauteur du guide en ruban est comprise entre 250nm et 350nm, en particulier 300nm,
- le guide d'onde en ruban et l'arête longitudinale sont chacun formés de silicium cristallin ou l'un en silicium cristallin et l'autre en silicium amorphe,
- l'arête longitudinale est en silicium cristallin et le guide d'onde en ruban est formé par deux couches dont celle en contact avec l'arête longitudinale également en silicium cristallin et dont l'autre proximale au milieu amplificateur en silicium amorphe.

L'invention concerne également un procédé de fabrication d'un dispositif laser, notamment tel que défini ci-dessus, comprenant les étapes suivantes :
- on réalise un guide d'onde en arête présentant un guide d'onde en ruban doté d'une arête longitudinale dans une couche de silicium disposée au-dessus d'une couche isolante enterrée, elle-même disposée au-dessus d'un substrat support,
- on encapsule par une couche isolante le guide d'onde en arête,
- on retourne l'ensemble,
- on enlève le substrat de support ainsi que la couche isolante enterrée jusqu'à découvrir une face du guide d'onde en ruban,
- on réalise par gravure au moins un réseau de Bragg dans la face du guide d'onde en ruban,
- on dépose une couche isolante et on réalise un polissage mécano-chimique de cette couche,
- on dépose une hétérostructure formée de matériau semiconducteur III-V,
- on réalise une gravure chimique sélective de l'hétérostructure pour obtenir un milieu amplificateur.

L'invention concerne également un procédé de fabrication d'un dispositif laser, notamment tel que défini ci-dessus, comprenant les étapes suivantes :
- on réalise un guide d'onde en arête présentant un guide d'onde en ruban doté d'une arête longitudinale dans une couche de silicium disposée au-dessus d'une couche isolante enterrée, elle-même disposée au-dessus d'un substrat support,
- on encapsule par une couche isolante le guide d'onde en arête,
- on retourne l'ensemble,
- on enlève le substrat de support ainsi que la couche isolante enterrée jusqu'à découvrir une face du guide d'onde en ruban,
- on dépose une couche de silicium amorphe sur la face du guide d'onde en ruban,
- on réalise par gravure au moins un réseau de Bragg dans la couche de silicium amorphe,
- on dépose une couche isolante et on réalise un polissage mécano-chimique de cette couche,
- on dépose une hétérostructure formée de matériau semiconducteur III-V,
- on réalise une gravure chimique sélective de l'hétérostructure pour obtenir un milieu amplificateur.

### DESCRIPTION SOMMAIRE DES DESSINS

D'autres avantages et caractéristiques apparaîtront à la lecture de la description de l'invention, ainsi que des figures suivantes sur lesquelles :
- la figure 1 montre un premier mode de réalisation d'un dispositif laser selon l'invention selon une vue schématique en coupe longitudinale,
- la figure 2 montre le dispositif laser de la figure 1 selon une vue schématique en coupe transversale selon la ligne de coupe II-II de la figure 1,
- la figure 3A montre une représentation schématique en perspective du guide d'onde en arête du dispositif laser de la figure 1,
- la figure 3B montre une représentation schématique en coupe longitudinale du guide d'onde en arête du dispositif laser de la figure 1,
- la figure 4 montre une vue partielle de dessus du dispositif laser de la figure 1,
- les figures 5A, 6A/6B à 14A/14B montrent des vues schématiques en coupe pour illustrer un procédé de fabrication d'un dispositif laser selon l'invention, les figures « A » étant des vues schématiques en coupe longitudinale tandis que les figures « B » sont des vues correspondantes en coupe transversale.
- la figure 15 montre un second mode de réalisation d'un dispositif laser selon l'invention selon une vue schématique en coupe longitudinale,
- la figure 16 montre le dispositif laser de la figure 15 selon une vue schématique en coupe transversale selon la ligne de coupe XVI-XVI de la figure 15,
- la figure 17A montre une représentation schématique en perspective du guide d'onde en arête du dispositif laser de la figure 15,
- la figure 17B montre une représentation schématique en coupe longitudinale du guide d'onde en arête du dispositif laser de la figure 15, et
- la figure 18 montre une vue partielle de dessus du dispositif laser de la figure 15.

### DESCRIPTION DE MODES DE REALISATIONS

Sur toutes les figures, les éléments identiques portent les mêmes numéros de référence.

Dans le présent exposé, le terme « longitudinal » doit être compris sensiblement parallèlement au sens de propagation de la lumière (voir flèche F1) et le terme « transversal » doit être compris sensiblement transversalement au sens de propagation de la lumière.

Par convention, sur un circuit optique réalisé dans un plan donné, il est défini des états de polarisation TE (pour " transverse electric " en anglais) et TM (pour " transverse magnetic " en anglais) tels que dans l'état TE le champ électrique est parallèle au plan du circuit, alors que le champ magnétique est perpendiculaire au plan du circuit, et dans l'état TM le champ magnétique est parallèle au plan du circuit tandis que le champ électrique est perpendiculaire au plan du circuit. En fait, dans le laser il faudra implicitement considérer un état de polarisation quasi-TE, c'est à dire que le champ électrique est très majoritairement polarisé selon sa direction TE. Ainsi, la structure du laser telle que décrite permettra préférentiellement un couplage du mode TE ou quasi-TE de l'onde.

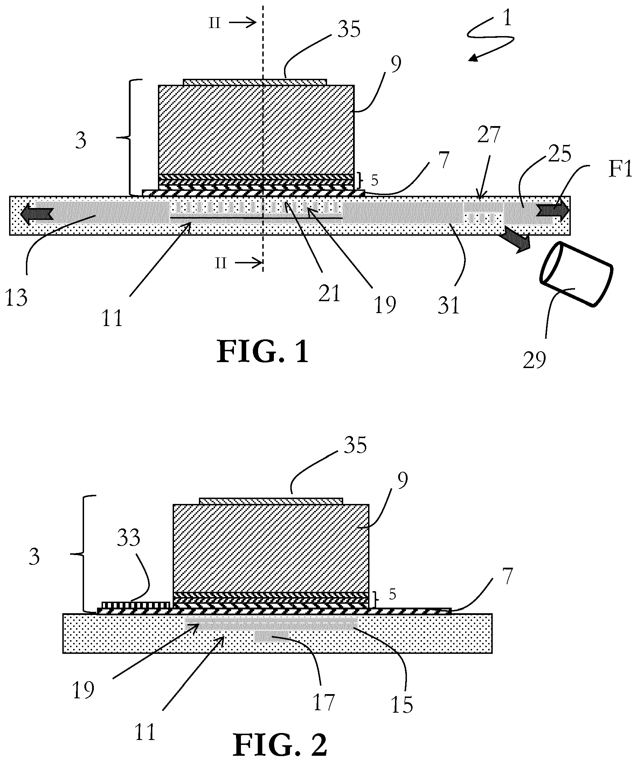

Les figures 1 à 4 présentent un premier mode de réalisation d'un dispositif laser 1 selon l'invention. Dans ce mode de réalisation, il s'agit d'un dispositif laser à rétroaction distribuée intégré sur silicium et à hétéro structure III-V dopée.

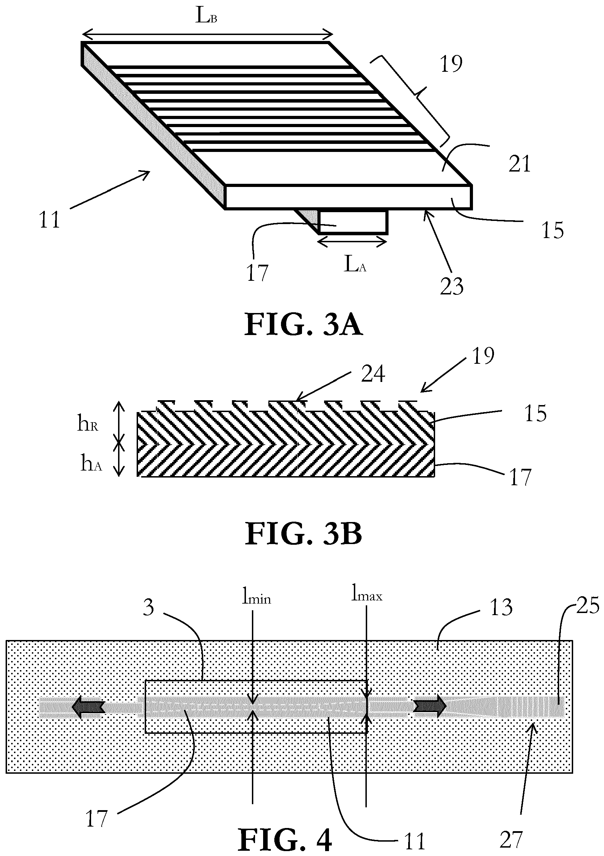

La figure 1 est une vue schématique en coupe longitudinale, la figure 2 une vue en coupe transversale selon la ligne de coupe II-II, la figure 3A montre une représentation schématique en perspective du guide d'onde en arête du dispositif laser de la figure 1 et la figure 4 montre une vue partielle de dessus du dispositif laser 1.

Le dispositif laser 1 comporte un milieu amplificateur optique 3 à hétérostructure de type III-V, l'hétérostructure étant agencée pour générer des photons, autrement dit une onde optique.

Par hétérostructure de type III- V, on entend l'utilisation de matériaux pouvant être choisis dans la liste non exhaustive suivante : InP, GaAs, InGaAlAs, InGaAsP, AlGaAs, InAsP. L'hétérostructure d'un tel milieu amplificateur 3, aussi appelé milieu à gain, peut comporter un empilement de diverses couches, comme par exemple un empilement de couches 5 formant des puits quantiques prises en sandwich entre une première couche 7 dopée, de préférence dopée N, et une seconde couche 9 dopée, de préférence dopée P.

Typiquement la couche 9 sera dopée P dans les 10¹⁹ cm³ et la couche 7 dans les 10¹⁸ cm³. Plus précisément, les couches 7 et 9 peuvent elles-mêmes être formées par épitaxie et être composées de plusieurs sous-couches, à dopage variable (le dopage diminue lorsque l'on se rapproche des puits quantiques). Les puits quantiques ne sont pas dopés.

La première couche 7 dopée, lorsqu'elle est dopée N, peut comporter un matériau choisi, pour l'essentiel, parmi InP, GaAs, InGaAsP, InGaAIAs, AIGaAs, InAsP. La seconde couche 9 dopée, lorsqu'elle est dopée P, peut comporter un matériau choisi parmi InP, GaAs, InGaAsP, InGaAIAs. Autrement dit, les matériaux utilisés pour la première couche 7 et la seconde couche 9 peuvent être les mêmes, seul le dopage change.

Bien entendu, le dopage peut être inversé, c'est-à-dire que la première couche 7 dopée peut être dopée P, et la seconde couche 9 dopée peut être dopée N. L'empilement de couches 5 peut comporter des puits quantiques ou des boîtes quantiques permettant la recombinaison de trous et d'électrons pour former des photons, et ainsi générer l'onde optique au niveau du milieu amplificateur 3. Les éléments (puits ou boîtes) quantiques peuvent comporter un matériau tels que InP, GaAs, InGaAsP, InGaAlAs, AlGa, As, InAsP.

L'épaisseur du milieu amplificateur à hétéro-structure 3 est typiquement de l'ordre de plusieurs microns.

L'épaisseur de l'empilement de puits quantiques 5 est de l'ordre de 200-400nm, par exemple de 300 nm et l'épaisseur de la couche 7 est de l'ordre de 100-200nm. La couche 9 peut avoir une épaisseur comprise entre 1-3µm.

Comme cela est représenté sur les figures 1 et 2, sous le milieu amplificateur 3 est disposé un guide d'onde optique en arête 11 intégré ou formé dans une couche de silicium sur isolant 13 (SOI en anglais pour « silicon on insulator »).

Ce guide d'onde en arête 11 est disposé en regard du milieu amplificateur 3 et se compose d'un guide d'onde en ruban 15 doté d'une arête longitudinale 17 (voir figures 2 et 3A). Le guide d'onde en ruban 15 et l'arête longitudinale 17 sont par exemple formés de silicium cristallin tous les deux.

Cependant d'autres options sont possibles. On note en particulier un premier cas où le guide d'onde en ruban 15 est en silicium cristallin et l'arête longitudinale 17 est en silicium amorphe.

Selon un second cas particulièrement intéressant, l'arête longitudinale 17 est en silicium cristallin et le guide d'onde en ruban 15 est formé par deux couches dont celle en contact avec l'arête longitudinale 17 également en silicium cristallin et dont l'autre proximale au milieu amplificateur 3 en silicium amorphe, c'est-à-dire la couche qui est au plus près du milieu amplificateur 3. L'arête longitudinale 17 et la couche en silicium cristallin du guide d'onde en ruban 15 sont dans la couche 13 de silicium sur isolant (SOI) tandis que la couche en silicium amorphe se trouve dans une couche isolante au-dessus de la couche de silicium sur isolant. Cet arrangement permet de garder une compatibilité maximale avec des processus et dispositifs photoniques silicium en face avant existants et de minimiser le budget thermique appliqué à la couche de silicium amorphe

Vus en coupe (Fig. 2), le guide d'onde en ruban 15 et l'arête longitudinale 17 sont rectangulaires tous les deux, mais leur largeur peut varier dans le sens de propagation de la lumière (exemple en Fig. 4). Le guide d'onde optique en arête 11 est orienté de manière qu'un réseau de Bragg 19 est réalisé sur la face 21 du guide d'onde en ruban 15 qui est proximale par rapport au milieu amplificateur optique 3. Par « proximal », on entend ici que le réseau de Bragg 19 est réalisé sur la face 21 qui est la plus proche du milieu amplificateur 3, ce qui permet un couplage optique plus efficace entre le réseau de Bragg 19 d'une part et le milieu amplificateur 3 d'autre part. La réflectivité du réseau de Bragg peut être comprise entre 65% et 80%. Pour un réseau DFB de 500µm/1mm de long, il faut un coefficient de couplage contre-réactionnel compris entre 10 et 30 cm-1. Pour une épaisseur de collage de 100nm, le réseau devra être gravé au minimum de 100nm dans le ruban, et la largeur de l'arête (L_{A}) pourra être inférieure à 500nm.

L'arête longitudinale 17 disposée sous le guide d'onde en ruban 15 (comme représenté sur les figures 1 à 4) est distale par rapport au milieu amplificateur 3. Par « distale », on entend ici que l'arête 17 est disposée sur la face 23 opposée à la face 21 : la face 23 est la plus éloignée du milieu amplificateur 3.

Ceci est également bien visible sur la figure 3A montrant le guide d'onde en arête 11 de façon isolée.

Comme on peut le voir sur la figure 3A, la largeur L_{B} du réseau de Bragg 19 est supérieure à la largeur L_{A} de l'arête. En particulier la largeur L_{B} du réseau de Bragg 19 est égale à la largeur du guide d'onde en ruban 15.

Grâce à ces dispositions, le couplage entre le réseau de Bragg 19 et le milieu amplificateur 3 est amélioré.

De plus, on peut choisir la largeur L_{B} du réseau de Bragg 19 indépendamment de la largeur L_{A} de l'arête et sans influence sur la réflectivité du réseau de Bragg 19.

La figure 3B montre une vue schématique en coupe longitudinale (dans le sens de propagation de la lumière) du guide en arête 11.

Le réseau de Bragg 19 présente une lame quart d'onde 24 située au centre du réseau 19 pour assurer un fonctionnement monomode du dispositif laser 1.

La hauteur h_{A} de l'arête est comprise entre 100nm et 250nm, en particulier 200nm.

La hauteur h_{R} du guide en ruban 15 est comprise entre 250nm et 350nm, en particulier 300nm.

On se réfère maintenant à la figure 4 montrant une vue partielle de dessus du dispositif laser de la figure 1.

En particulier sous forme de pointillés, on distingue la forme de l'arête 17 qui s'élargit en direction d'un guide d'onde de sortie 25 pour former un transformateur de mode.

La largeur minimale lₘᵢₙ de l'arête 17 est comprise entre 0.4µm et 0.7µm.

La largeur maximale lₘₐₓ de l'arête 17 est supérieure à 1µm, notamment 1.1µm et peut monter jusqu'à 3µm.

On se réfère maintenant aux figures 1 et 4. Comme on voit sur ces figures, le dispositif laser 1 comporte en outre un réseau de sortie 27.

Ce réseau 27 de couplage avec une fibre optique 29 peut comporter un réseau de tranchées réalisées partiellement dans le guide d'onde 11, par exemple par gravure de ce dernier. De préférence, les tranchées sont sensiblement perpendiculaires à l'axe longitudinal du guide d'onde 11, et sont formées sur une face inférieure du guide d'onde 11, la face inférieure 31 étant sur la figure 1 la face du guide d'onde 11 orientée vers le bas et sensiblement parallèle au plan du guide d'onde 11. Pour un guide d'onde 11 selon les dimensions précitées, les tranchées peuvent avoir une profondeur de 125nm, voire plus si nécessaire. Le réseau peut, par exemple, être défini en utilisant un masque dur, puis une gravure directionnelle.

Par ailleurs, des dépôts eutectiques 33 et 35, respectivement déposés sur la première couche dopée 7 et la seconde couche dopée 9 permettent de prendre des contacts métalliques sur les couches 7 et 9.

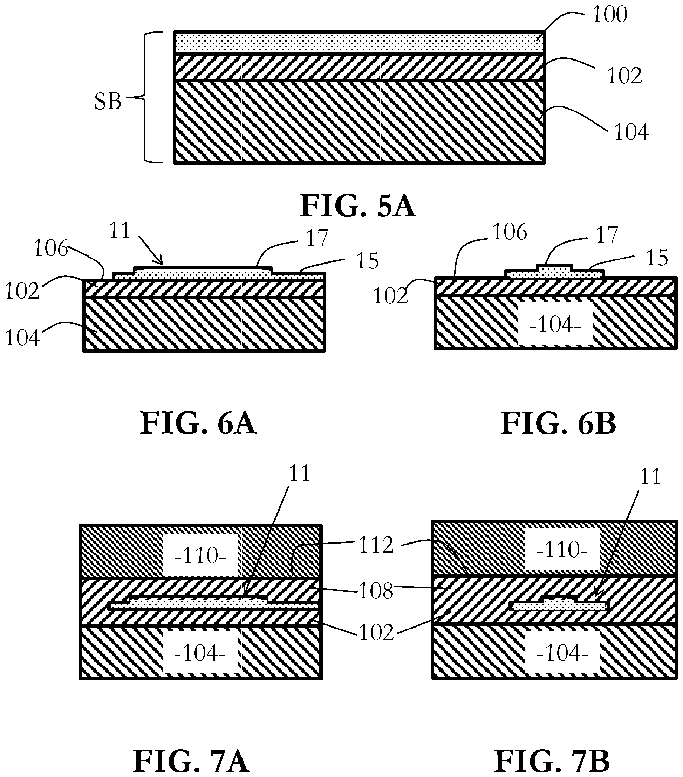

En référence aux figures 5, 6A/6B à 14A/14B on va maintenant décrire un procédé de fabrication d'un dispositif laser 1 selon l'invention.

Les figures 5A, 6A/6B à 14A/14B montrent des vues schématiques en coupe, les figures « A » étant des vues schématiques en coupe longitudinale tandis que les figures « B » sont des vues correspondantes en coupe transversale.

Comme on le voit sur la figure 5A, la référence SB désigne un substrat du type Silicium-sur-isolant (SOI : « Silicon-on-Insulator » en anglais) d'une plaquette ou « wafer ».

Ce substrat « SOI » comporte une couche ou film de silicium 100 ayant par exemple une épaisseur comprise entre 200nm et 1µm typiquement de 500nm et disposée au-dessus d'une couche isolante enterrée 102, communément désignée BOX (pour « Buried OXide » en anglais). Cette couche isolante enterrée 102 est elle-même disposée au-dessus d'un substrat de support 104.

Lors d'une première étape visible sur les figures 6A et 6B, on structure la couche de silicium 100, par exemple par gravure, pour obtenir un guide d'onde en arête 11. Si le dispositif laser 1 fait partie d'un ensemble fonctionnel plus important, d'autres composants (modulateurs, photodétecteurs etc) peuvent être réalisés lors de cette étape sur la face supérieure 106 de la couche BOX 102.

Comme on le voit sur les figures 7A et 7B, une couche d'isolant 108, par exemple du SiO2 est déposée pour encapsuler le guide d'onde en arête 11. Puis un substrat de support 110 est collé sur la face supérieure 112 de la couche isolante 108.

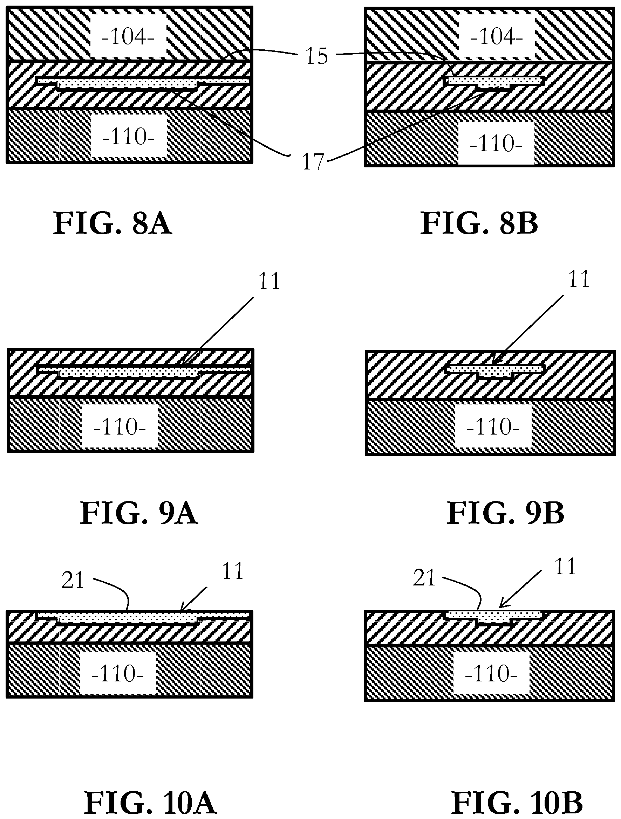

Lors de la prochaine étape (figures 8A et 8B), on retourne l'ensemble de sorte que l'arête 17 est dirigée vers le bas de la figure et le guide en ruban 15 se trouve par-dessus.

Ensuite, on enlève la couche de substrat de support 104 par exemple par abrasion ou par polissage mécano-chimique (« grinding » en anglais). La couche de BOX 102 (qui peut servir de couche d'arrêt du polissage) se trouve alors en haut complètement découverte (voir figures 9A et 9B).

Puis, on retire la couche de BOX 102 par chimie humide sélective ou par gravure sèche par exemple la gravure ionique réactive (« RIE » pour « reactive ion etching » en anglais) ou la gravure plasma couplé par induction (« ICP » pour « inductively coupled plasma » en anglais) de façon à découvrir la face 21 du guide d'onde en ruban 15 qui sera tournée, comme on le verra, vers le milieu amplificateur 3 (voir figures 10A et 10B).

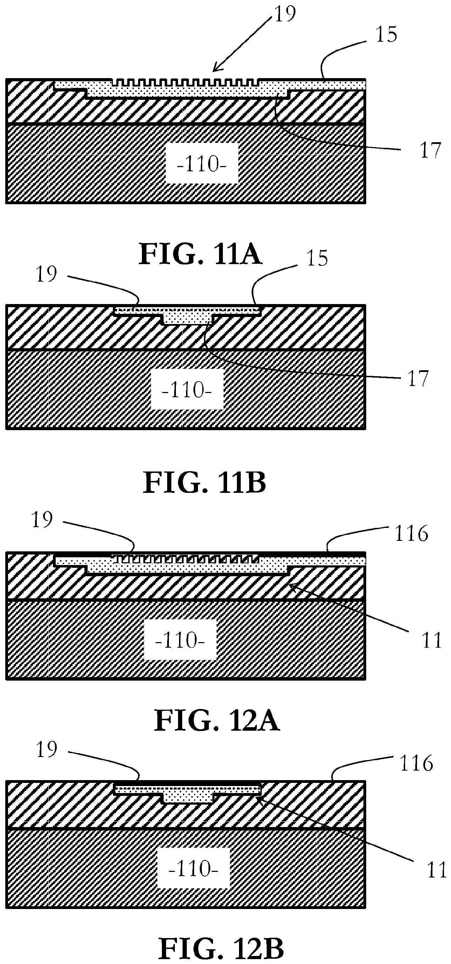

Lors de la prochaine étape (voir figures 11A et 11B) montrant une première variante, le réseau de Bragg 19 est gravé (ou structuré) dans la face 21 de la couche de silicium 100 ainsi exposée, de préférence sur toute la largeur du guide en ruban 15.

Selon une seconde variante non représentée, on dépose sur la partie du guide d'onde en ruban une couche supplémentaire de silicium amorphe et le réseau de Bragg est gravé (ou structuré) dans cette couche supplémentaire en silicium amorphe. Dans ce cas, l'arête longitudinale 17 est donc en silicium cristallin et le guide d'onde en ruban 15 est formé par deux couches dont celle en contact avec l'arête longitudinale 17 également en silicium cristallin et dont l'autre proximale au milieu amplificateur 3 en silicium amorphe. L'arête longitudinale 17 et la couche en silicium cristallin du guide d'onde en ruban 15 sont dans la couche 13 de silicium sur isolant (SOI).

Ceci permet de garder une compatibilité maximale avec des processus et dispositifs photoniques en silicium existants (par exemple des modulateurs ou photodétecteurs) et de minimiser le budget thermique appliqué à la couche de silicium amorphe.

Puis, on dépose, aussi bien dans le cas de la première que de la seconde variante, une couche additionnelle 116 d'isolant, par exemple en SiO₂ d'une centaine de nm sur toute la face ainsi découverte (voir figures 12A et 12B). On peut ensuite soumettre cette couche additionnelle 116 à un polissage mécano-chimique.

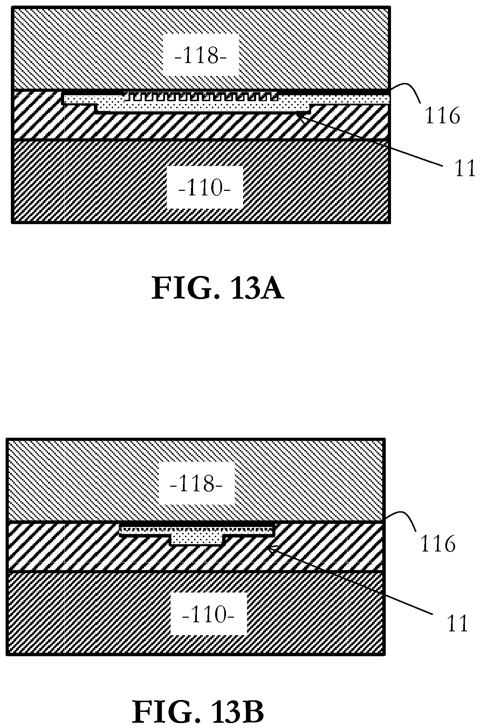

Ensuite, on prend par exemple une plaquette III-V 118 comportant sur une face une hétérostructure III-V. Puis, on colle la plaquette 118, par exemple par collage moléculaire sur la couche additionnelle 116 (voir figures 13A et 13B), de façon que l'hétérostructure se trouve en contact avec la structure réalisée précédemment dans le silicium.

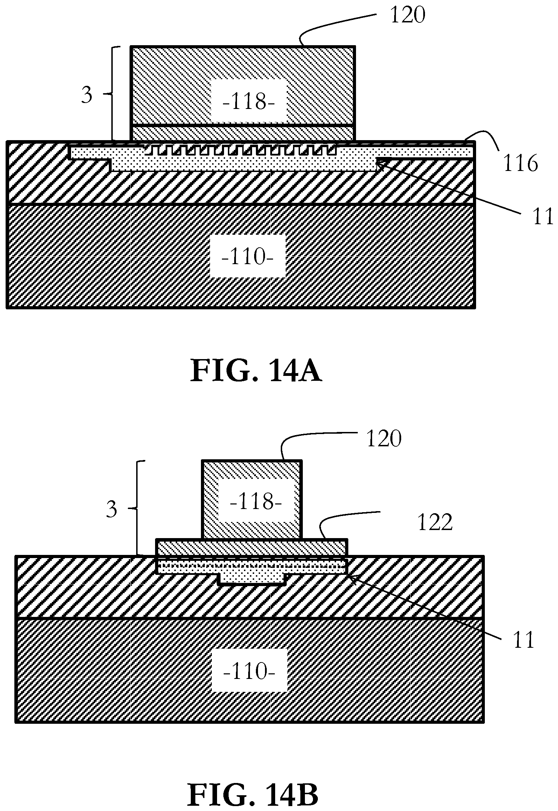

Enfin, on procède à une gravure chimique sélective du substrat de la plaquette collée 118 de façon à obtenir le milieu amplificateur 3 (voir figures 14A et 14B). Par souci de simplification, on n'a pas représenté les couches 9, 5 et 7 du milieu 3.

On peut ensuite procéder à des dépôts eutectiques, par exemple à base d'or, de façon à pouvoir prendre des contacts métalliques sur les couches gravées 120 et 122.

Puis, l'ensemble peut être encapsulé par dépôt d'une autre couche isolante et on peut réaliser de façon classique des contacts métalliques.

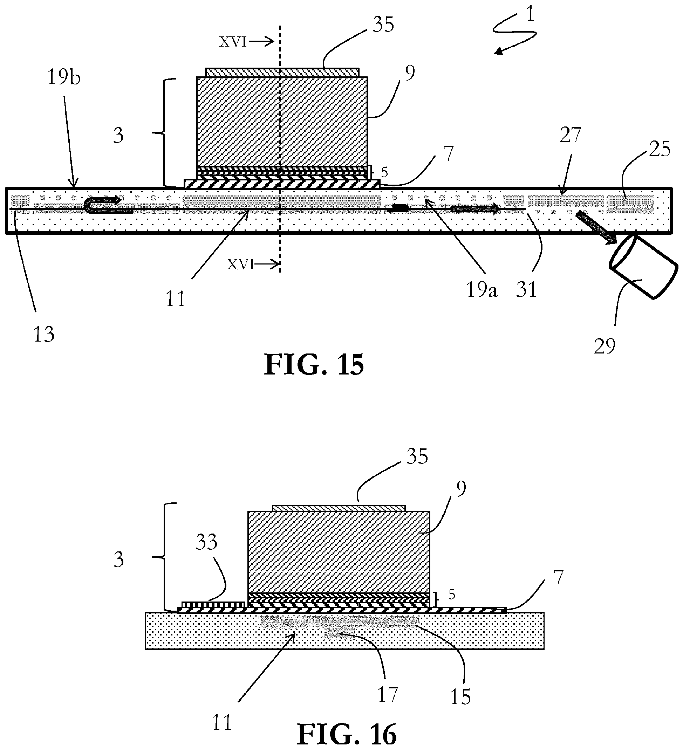

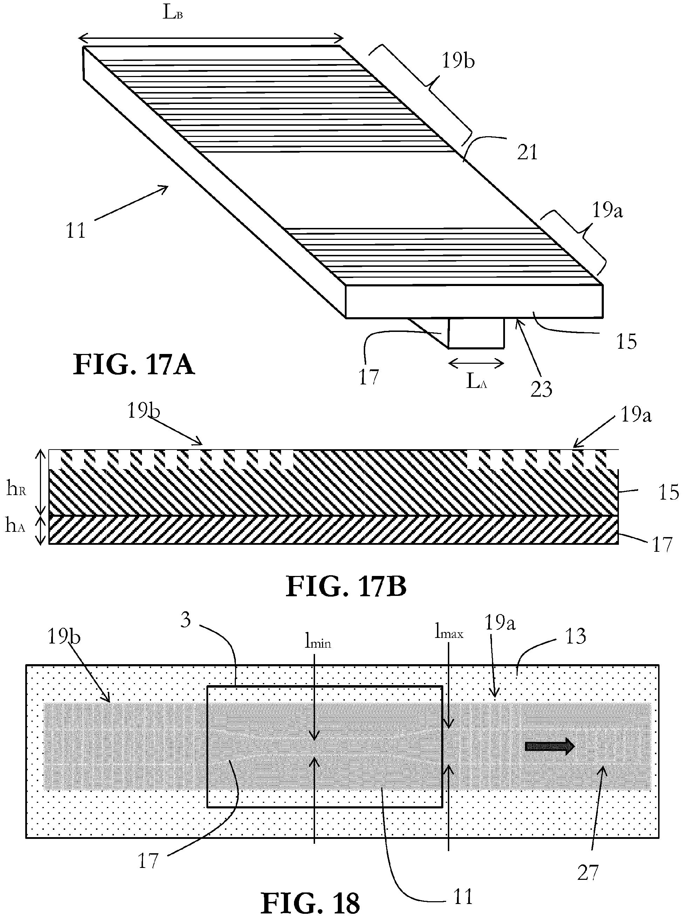

Les figures 15 à 18 présentent un second mode de réalisation d'un dispositif laser 1 selon l'invention. Dans ce mode de réalisation, il s'agit d'un dispositif laser à réseaux de Bragg distribués.

Les figures 15 à 18 sont des vues analogues à celles des figures 1 à 4 et le dispositif laser sur ces figures 15 à 18 se distingue par le fait qu'il comprend deux réseaux de Bragg 19a et 19b disposés de part et d'autre par rapport au milieu amplificateur 3 à hétérostructure III-V. Les réseaux 19a et 19b sont donc réalisés sur la face 21 qui est proximale par rapport au milieu amplificateur 3, mais en dehors de l'empreinte de ce milieu amplificateur 3 et à un endroit où l'arête 17 est la plus élargie (lₘₐₓ).

Comme on le voit sur les figures 15, 17A, 17B et 18, le réseau 19a qui se trouve du côté du réseau de sortie 27 est plus court et possède une réflectivité plus faible, de l'ordre de 50%, que le réseau 19b sur le côté opposé du milieu amplificateur 3 qui lui peut posséder une réflectivité supérieure à 90%, voire approchant 100%.

Le procédé de fabrication décrit en relation avec les figures 5, 6A/6B à 14A/14B s'applique de manière analogue pour la fabrication d'un dispositif laser selon ce mode de réalisation d'un dispositif laser à réseaux de Bragg distribués.

On voit donc que le dispositif laser 1 selon l'invention peut être réalisé aisément avec un nombre réduit d'étapes de fabrication.

Par les dispositions du guide d'onde en arête 11, notamment dans la configuration des figures 1 à 4, on a observé que les valeurs de coefficient de couplage de la contreréaction du réseau de Bragg 19 sur la face proximale du guide en ruban 15 sont plus élevées que dans l'état de la technique, notamment par rapport à une configuration où le réseau de Bragg est structuré sur l'arête.

Par ailleurs, les inventeurs ont de plus pu observer une diminution de l'influence de la profondeur de gravure sur la valeur du coefficient de couplage de la contre-réaction augmentant ainsi la robustesse du procédé de fabrication.

## Revendications

1. Dispositif laser (1) disposé dans et/ou sur silicium et à hétéro structure III-V comprenant
- un milieu amplificateur (3) à hétérostructure III-V, et
- un guide d'onde optique en arête (11), disposé en regard du milieu amplificateur (3) et comprenant un guide d'onde en ruban (15) doté d'une arête longitudinale (17), le guide d'onde optique en arête (11) étant disposé dans du silicium,
**caractérisé en ce que** le guide d'onde optique en arête (11) est orienté de manière à ce qu'au moins un réseau de Bragg (19, 19a, 19b) est disposée sur la face (21) du guide d'onde en ruban (15) qui est proximale par rapport au milieu amplificateur (3) et **en ce que** l'arête (17) est disposée sur la face (23) du guide d'onde en ruban (15) qui est distale par rapport au milieu amplificateur (3).

2. Dispositif laser selon la revendication 1, **caractérisé en ce qu'**il comprend deux réseaux de Bragg (19a, 19b) disposés de part et d'autre par rapport au milieu amplificateur (3) à hétérostructure III-V.

3. Dispositif laser selon la revendication 2, **caractérisé en ce que** le réseau de Bragg (19a) qui se trouve du côté d'un réseau de sortie (27) possède une réflectivité de l'ordre de 50% et que le réseau de Bragg (19b) sur le côté opposé du milieu amplificateur (3) possède une réflectivité supérieure à 90%.

4. Dispositif laser selon la revendication 1, **caractérisé en ce qu'**il comprend un réseau de Bragg (19) en regard du milieu amplificateur (3) à hétérostructure III-V.

5. Dispositif laser selon la revendication 4, **caractérisé en ce que** le réseau de Bragg (19) comprend une lame quart d'onde (24) pour assurer un fonctionnement monomode.

6. Dispositif laser selon l'une quelconque des revendications 4 à 5, **caractérisé en ce que** la réflectivité du réseau de Bragg (19) est comprise entre 65% et 80%.

7. Dispositif laser selon l'une quelconque des revendications 1 à 6, **caractérisé en ce que** la largeur du réseau de Bragg (19) est supérieure à celle de l'arête (17).

8. Dispositif laser selon l'une quelconque des revendications 1 à 7, **caractérisé en ce que** la largeur du réseau de Bragg (19) est sensiblement égale à la largeur du guide d'onde en ruban (15).

9. Dispositif laser selon l'une quelconque des revendications 1 à 8, **caractérisé en ce que** la largeur de l'arête (17) du guide d'onde en arête (11) augmente en direction d'un guide d'onde (25) de sortie pour former un transformateur de mode.

10. Dispositif laser selon l'une quelconque des revendications 1 à 9 **caractérisé en ce que** le guide d'onde en ruban (15) et l'arête longitudinale (17) sont chacun formés de silicium cristallin ou l'un en silicium cristallin et l'autre en silicium amorphe.

11. Dispositif laser selon l'une quelconque des revendications 1 à 10, **caractérisé en ce que** l'arête longitudinale (17) est en silicium cristallin et le guide d'onde en ruban (15) est formé par deux couches dont celle en contact avec l'arête longitudinale (17) également en silicium cristallin et dont l'autre proximale au milieu amplificateur (3) en silicium amorphe.

12. Procédé de fabrication d'un dispositif laser comprenant les étapes suivantes :
- on réalise un guide d'onde en arête (11) présentant un guide d'onde en ruban doté d'une arête longitudinale dans une couche de silicium (100) disposée au-dessus d'une couche isolante enterrée (102), elle-même disposée au-dessus d'un substrat support (104),
- on encapsule par une couche isolante (110) le guide d'onde en arête (11),
- on retourne l'ensemble,
- on enlève le substrat de support (104) ainsi que la couche isolante enterrée (102) jusqu'à découvrir une face du guide d'onde en ruban (15),
- on réalise par gravure au moins un réseau de Bragg (19) dans la face (21) du guide d'onde en ruban (15),
- on dépose une couche isolante (116) et on réalise un polissage mécano-chimique de cette couche
- on dépose une hétérostructure (118) formée de matériau semiconducteur III-V,
- on réalise une gravure chimique sélective de l'hétérostructure (118) pour obtenir un milieu amplificateur (3).

13. Procédé de fabrication d'un dispositif laser comprenant les étapes suivantes :
- on réalise un guide d'onde en arête (11) présentant un guide d'onde en ruban doté d'une arête longitudinale dans une couche de silicium (100) disposée au-dessus d'une couche isolante enterrée (102), elle-même disposée au-dessus d'un substrat support (104),
- on encapsule par une couche isolante (110) le guide d'onde en arête (11),
- on retourne l'ensemble,
- on enlève le substrat de support (104) ainsi que la couche isolante enterrée (102) jusqu'à découvrir une face du guide d'onde en ruban (15),
- on dépose une couche de silicium amorphe sur la face du guide d'onde en ruban (15),
- on réalise par gravure au moins un réseau de Bragg (19) dans la couche de silicium amorphe,
- on dépose une couche isolante (116) et on réalise un polissage mécano-chimique de cette couche,
- on dépose une hétérostructure (118) formée de matériau semiconducteur III-V,
- on réalise une gravure chimique sélective de l'hétérostructure (118) pour obtenir un milieu amplificateur (3).

## Patentansprüche

1. Laservorrichtung (1); die in und/oder auf Silicium angeordnet ist und eine III-V-Heterostruktur hat, die enthält
- ein verstärkendes Medium (3) mit III-V-Heterostrukur, und
- einen optischen Rippenwellenleiter (11), der gegenüber dem verstärkenden Medium (3) angeordnet ist und einen Streifenwellenleiter (15) enthält, der mit einer Längsrippe (17) versehen ist, wobei der optische Rippenwellenleiter (11) in Silicium angeordnet ist,
**dadurch gekennzeichnet, dass** der optische Rippenwellenleiter (11) so ausgerichtet ist, dass mindestens ein Bragg-Gitter (19, 19a, 19b) auf der Seite (21) des Streifenwellenleiter (15) angeordnet ist, die bezüglich des verstärkenden Mediums (3) proximal ist, und dass die Rippe (17) auf der Seite (23) des Streifenwellenleiters (15) angeordnet ist, die bezüglich des verstärkenden Mediums (3) distal ist.

2. Laservorrichtung nach Anspruch 1, **dadurch gekennzeichnet, dass** sie zwei Bragg-Gitter (19a, 19b) enthält, die zu beiden Seiten bezüglich des verstärkenden Mediums (3) mit III-V-Heterostrukur angeordnet sind.

3. Laservorrichtung nach Anspruch 2, **dadurch gekennzeichnet, dass** das Bragg-Gitter (19a), das sich auf der Seite eines Ausgangsgitters (27) befindet, ein Reflexionsvermögen in der Größenordnung von 50% besitzt, und dass das Bragg-Gitter (19b) auf der entgegengesetzten Seite des verstärkenden Mediums (3) ein Reflexionsvermögen von mehr als 90% besitzt.

4. Laservorrichtung nach Anspruch 1, **dadurch gekennzeichnet, dass** sie ein Bragg-Gitter (19) gegenüber dem verstärkenden Medium (3) mit III-V-Heterostrukur enthält.

5. Laservorrichtung nach Anspruch 4, **dadurch gekennzeichnet, dass** das Bragg-Gitter (19) ein Viertelwellenplättchen (24) enthält, um einen Monomode-Betrieb zu gewährleisten.

6. Laservorrichtung nach einem der Ansprüche 4 bis 5, **dadurch gekennzeichnet, dass** das Reflexionsvermögen des Bragg-Gitters (19) zwischen 65% und 80% liegt.

7. Laservorrichtung nach einem der Ansprüche 1 bis 6, **dadurch gekennzeichnet, dass** die Breite des Bragg-Gitters (19) größer als diejenige der Rippe (17) ist.

8. Laservorrichtung nach einem der Ansprüche 1 bis 7, **dadurch gekennzeichnet, dass** die Breite des Bragg-Gitters (19) im Wesentlichen gleich der Breite des Streifenwellenleiters (15) ist.

9. Laservorrichtung nach einem der Ansprüche 1 bis 8, **dadurch gekennzeichnet, dass** die Breite der Rippe (17) des Rippenwellenleiters (11) in Richtung eines Ausgangswellenleiters (25) zunimmt, um einen Wellenformwandler zu bilden.

10. Laservorrichtung nach einem der Ansprüche 1 bis 9, **dadurch gekennzeichnet, dass** der Streifenwellenleiter (15) und die Längsrippe (17) je aus kristallinem Silicium oder der/die eine aus kristallinem Silicium und der/die andere aus amorphem Silicium gebildet sind.

11. Laservorrichtung nach einem der Ansprüche 1 bis 10, **dadurch gekennzeichnet, dass** die Längsrippe (17) aus kristallinem Silicium ist und der Streifenwellenleiter (15) von zwei Schichten gebildet wird, von denen diejenige in Kontakt mit der Längsrippe (17) ebenfalls aus kristallinem Silicium und die andere proximal zum verstärkenden Medium (3) aus amorphem Silicium ist.

12. Verfahren zur Herstellung einer Laservorrichtung, das die folgenden Schritte enthält:
- es wird ein Rippenwellenleiter (11) hergestellt, der einen mit einer Längsrippe versehenen Streifenwellenleiter in einer Siliciumschicht (100) aufweist, die über einer vergrabenen Isolierschicht (102) angeordnet ist, die selbst über einem Trägersubstrat (104) angeordnet ist,
- der Rippenwellenleiter (11) wird durch eine Isolierschicht (110) eingekapselt,
- die Einheit wird umgedreht,
- das Trägersubstrat (104) sowie die vergrabene Isolierschicht (102) werden entfernt, bis eine Seite des Streifenwellenleiters (15) aufgedeckt wird,
- mindestens ein Bragg-Gitter (19) wird durch Ätzen in der Seite (21) des Streifenwellenleiters (15) hergestellt,
- eine Isolierschicht (116) wird aufgebracht und ein mechanisch-chemisches Polieren dieser Schicht durchgeführt
- eine aus III-V-Halbleitermaterial gebildete Heterostruktur (118) wird aufgebracht,
- ein selektives chemisches Ätzen der Heterostruktur (118) wird durchgeführt, um ein verstärkendes Medium (3) zu erhalten.

13. Verfahren zur Herstellung einer Laservorrichtung, das die folgenden Schritte enthält:
- es wird ein Rippenwellenleiter (11) hergestellt, der einen mit einer Längsrippe versehenen Streifenwellenleiter in einer Siliciumschicht (100) aufweist, die über einer vergrabenen Isolierschicht (102) angeordnet ist, die selbst über einem Trägersubstrat (104) angeordnet ist,
- der Rippenwellenleiter (11) wird durch eine Isolierschicht (110) eingekapselt,
- die Einheit wird umgedreht,
- das Trägersubstrat (104) sowie die vergrabene Isolierschicht (102) werden entfernt, bis eine Seite des Streifenwellenleiters (15) aufgedeckt wird,
- eine Schicht von amorphem Silicium wird auf der Seite des Streifenwellenleiters (15) aufgebracht,
- mindestens ein Bragg-Gitter (19) wird durch Ätzen in der Schicht aus amorphem Silicium hergestellt,
- eine Isolierschicht (116) wird aufgebracht und ein mechanisch-chemisches Polieren dieser Schicht durchgeführt,
- eine aus III-V-Halbleitermaterial gebildete Heterostruktur (118) wird aufgebracht,
- ein selektives chemisches Ätzen der Heterostruktur (118) wird durchgeführt, um ein verstärkendes Medium (3) zu erhalten.

## Claims

1. III-V heterostructure laser device (1) arranged in and/or on silicon, comprising:
- a III-V heterostructure gain medium (3); and
- an optical rib waveguide (11), arranged facing the gain medium (3) and comprising a slab waveguide (15) equipped with a longitudinal rib (17), the optical rib waveguide (11) being arranged in the silicon;
**characterised in that** the optical rib waveguide (11) is oriented so that at least one Bragg grating (19, 19a, 19b) is arranged on that side (21) of the slab waveguide (15) which is proximal relative to the gain medium (3) and **in that** the rib (17) is placed on that side (23) of the slab waveguide (15) that is distal relative to the gain medium (3).

2. Laser device according to Claim 1, **characterised in that** it comprises two Bragg gratings (19a, 19b) arranged on either side of the III-V heterostructure gain medium (3).

3. Laser device according to Claim 2, **characterised in that** the Bragg grating (19a) that is located on the same side as an output grating (27) possesses a reflectivity of about 50% and **in that** the Bragg grating (19b) on the side opposite the gain medium (3) possesses a reflectivity higher than 90%.

4. Laser device according to Claim 1, **characterised in that** it comprises a Bragg grating (19) facing the III-V heterostructure gain medium (3).

5. Laser device according to Claim 4, **characterised in that** the Bragg grating (19) comprises a quarter-wave plate (24) in order to ensure a single-mode operation.

6. Laser device according to either one of Claims 4 and 5, **characterised in that** the reflectivity of the Bragg grating (19) is comprised between 65% and 80%.

7. Laser device according to any one of Claims 1 to 6, **characterised in that** the width of the Bragg grating (19) is larger than that of the rib (17).

8. Laser device according to any one of Claims 1 to 7, **characterised in that** the width of the Bragg grating (19) is substantially equal to the width of the slab waveguide (15).

9. Laser device according to any one of Claims 1 to 8, **characterised in that** the width of the rib (17) of the rib waveguide (11) increases in the direction of an output waveguide (25) in order to form a mode converter.

10. Laser device according to any one of Claims 1 to 9, **characterised in that** the slab waveguide (15) and the longitudinal rib (17) are each formed from crystalline silicon or one from crystalline silicon and the other from amorphous silicon.

11. Laser device according to any one of Claims 1 to 10, **characterised in that** the longitudinal rib (17) is made of crystalline silicon and the slab waveguide (15) is formed by two layers, the layer making contact with the longitudinal rib (17) also being made of crystalline silicon and the other, which is proximal to the gain medium (3), being made of amorphous silicon.

12. Process for fabricating a laser device comprising the following steps:
- producing a rib waveguide (11) comprising a slab waveguide equipped with a longitudinal rib in a silicon layer (100) arranged above a buried insulating layer (102) itself arranged above a carrier substrate (104);
- encapsulating the rib waveguide (11) with an insulating layer (110);
- flipping the assembly;
- removing the carrier substrate (104) and the buried insulating layer (102) until one side of the slab waveguide (15) is exposed;
- producing by etching at least one Bragg grating (19) in the side (21) of the slab waveguide (15);
- depositing an insulating layer (116) and carrying out a chemical-mechanical polish of this layer;
- depositing a heterostructure (118) formed from III-V semiconductors; and
- carrying out a selective chemical etch of the heterostructure (118) in order to obtain a gain medium (3).

13. Process for fabricating a laser device comprising the following steps:
- producing a rib waveguide (11) comprising a slab waveguide equipped with a longitudinal rib in a silicon layer (100) arranged above a buried insulating layer (102) itself arranged above a carrier substrate (104);
- encapsulating the rib waveguide (11) with an insulating layer (110);
- flipping the assembly;
- removing the carrier substrate (104) and the buried insulating layer (102) until one side of the slab waveguide (15) is exposed;
- depositing an amorphous silicon layer on the side of the slab waveguide (15);
- producing by etching at least one Bragg grating (19) in the amorphous silicon layer;
- depositing an insulating layer (116) and carrying out a chemical-mechanical polish of this layer;
- depositing a heterostructure (118) formed from III-V semiconductors; and
carrying out a selective chemical etch of the heterostructure (118) in order to obtain a gain medium (3).
